# EUROPEAN PATENT APPLICATION

(11) **EP 4 801 216 A1**
(43) Date of publication of application: **02.09.2026**
(21) Application number: 24882437.7
(22) Date of filing: 24.10.2024
(51) Int. Cl.: H05K 9/00, H01F 1/34, H01Q 17/00

(54) **ARTICLE PROVIDED WITH RADIO WAVE ABSORBENT BODY, AND RADIO WAVE ABSORBENT BODY**

(30) Priority: 26.10.2023 JP 2023183918
(71) Applicant: FUJIFILM Corporation, Tokyo 106-8620 (JP)
(72) Inventor: HASHIMOTO, Hirokazu, Minamiashigara-shi, Kanagawa 250-0193 (JP); HATAKEYAMA, Koichi, Minamiashigara-shi, Kanagawa 250-0193 (JP)
(74) Representative: HGF
(86) International application number: PCT/JP2024/037872
(87) International publication number: WO 2025/089326

(57) **Abstract**

Provided is an article including a radio wave transmitter and a radio wave absorber. The radio wave absorber includes one or more kinds of particles selected from the group consisting of magnetic particles and dielectric particles, and a binder, and a ten-point average roughness Rz of at least one of a pair of main surfaces of the radio wave absorber facing each other is 25 µm or more and Y µm or less. The Y is a value calculated by Y = λ × 1000/10, where λ mm is a wavelength of a radio wave transmitted from the radio wave transmitter. Provided is also a radio wave absorber including one or more kinds of particles selected from the group consisting of magnetic particles and dielectric particles, and a binder, in which a ten-point average roughness Rz of at least one of a pair of main surfaces facing each other is 25 µm or more and 500 µm or less.

## Description

### [Technical Field]

The present invention relates to an article comprising a radio wave absorber and a radio wave absorber.

### [Background Art]

In recent years, a radio wave absorber for incorporation into various articles has been studied (for example, see PTL 1).

### [Citation List]

### [Patent Literature]

[PTL 1] JP2019-145534A

### [Summary of Invention]

### [Technical Problem]

As an article comprising a radio wave absorber, for example, a radar for recognizing an object by transmitting and receiving radio waves has attracted attention. For example, an on-vehicle radar can measure a direction in which an object is located, a distance to the object, and the like by transmitting radio waves and receiving reflected waves reflected by the object (a pedestrian, a vehicle, or the like) from the transmitted radio waves. An autonomous driving control system of an automobile can automatically apply a brake to stop the automobile or automatically control a speed to maintain a distance to the object, as necessary, based on a measurement result of the radar in order to prevent a collision with the object.

In order to improve the reliability of the system that carries out various controls based on the results obtained from the radar by recognizing the object as described above, it is desired to improve the performance of the radar. For this reason, in recent years, it has begun to be examined to install a radio wave absorber on a front side (an incident side of a radio wave incident from the outside) of a radio wave transmitting and receiving unit of a radar to improve the recognition accuracy.

For example, from the viewpoint of improving the recognition accuracy of the radar, it is desired that the radio wave absorber incorporated in the radar can exhibit excellent radio wave absorption characteristics. In addition, it is also desirable that the radio wave absorber can exhibit excellent radio wave absorption characteristics in other various applications in which the radio wave absorber is used.

On the other hand, for example, in a quality inspection before an article comprising a radio wave absorber is shipped, an inspector may inspect the presence or absence of a scratch. In addition, in a case where the article comprising the radio wave absorber is used, the radio wave absorber may be installed at a position where the radio wave absorber is visible.

For example, in the above-described case, it is desired that scratches generated on the radio wave absorber is hardly visible.

In view of the above, an object of an aspect of the present invention is to provide an article comprising a radio wave absorber that can exhibit excellent radio wave absorption characteristics and in which scratches are hardly visible.

### [Solution to Problem]

One aspect of the present invention is as follows.
[1] An article comprising:
   a radio wave transmitter; and
   a radio wave absorber,
   in which the radio wave absorber contains one or more kinds of particles selected from the group consisting of magnetic particles and dielectric particles, and a binder, and
   a ten-point average roughness Rz of at least one of a pair of main surfaces of the radio wave absorber facing each other (hereinafter, also simply referred to as "ten-point average roughness Rz" or "Rz") is 25 µm or more and Y µm or less,
   where the Y is a value calculated by Y = λ × 1000/10 in a case where a wavelength of a radio wave transmitted from the radio wave transmitter is defined as λ mm.
[2] The article according to [1], in which the Y is 500 or less.
[3] The article according to [1] or [2],
   in which the particles are magnetic particles, and the magnetic particles are particles of a hexagonal ferrite.
[4] The article according to [3], in which the hexagonal ferrite is a substituted hexagonal ferrite.
[5] The article according to [4],
   in which the substituted hexagonal ferrite is a magnetoplumbite-type hexagonal ferrite having a formulation represented by Formula 1,

      Formula 1 AFe₍₁₂₋ₓ₎AlₓO₁₉
   in Formula 1, A represents one or more kinds of atoms selected from the group consisting of Sr, Ba, Ca, and Pb, and x satisfies 0.50 ≤ x ≤ 8.00.
[6] The article according to [5], in which the atom represented by A in Formula 1 includes Sr.
[7] The article according to [1],
   in which the Y is 500 or less,
   the particle is a magnetic particle,
   the magnetic particles are particles of a hexagonal ferrite,
   the hexagonal ferrite is a substituted hexagonal ferrite, and
   the substituted hexagonal ferrite is a magnetoplumbite-type hexagonal ferrite having a formulation represented by Formula 1,

      **Formula 1** AFe₍₁₂₋ₓ₎AlₓO₁₉
   in Formula 1, A represents one or more kinds of atoms selected from the group consisting of Sr, Ba, Ca, and Pb, x satisfies 0.50 ≤ x ≤ 8.00, and an atom represented by A includes Sr.
[8] A radio wave absorber comprising: one or more kinds of particles selected from the group consisting of magnetic particles and dielectric particles; and a binder,
   in which a ten-point average roughness Rz of at least one of a pair of main surfaces facing each other is 25 µm or more and 500 µm or less.
[9] The radio wave absorber according to [8],
   in which the particles are magnetic particles, and the magnetic particles are particles of a hexagonal ferrite.
[10] The radio wave absorber according to [9], in which the hexagonal ferrite is a substituted hexagonal ferrite.
[11] The radio wave absorber according to [10],
   in which the substituted hexagonal ferrite is a magnetoplumbite-type hexagonal ferrite having a formulation represented by Formula 1,

      **Formula 1** AFe₍₁₂₋ₓ₎AlₓO₁₉
   in Formula 3, A represents one or more kinds of atoms selected from the group consisting of Sr, Ba, Ca, and Pb, and x satisfies 0.50 ≤ x ≤ 8.00.
[12] The radio wave absorber according to [11], in which the atom represented by A in Formula 1 includes Sr.
[13] The radio wave absorber according to [8],
   wherein the particle is a magnetic particle,
   the magnetic particles are particles of a hexagonal ferrite,
   the hexagonal ferrite is a substituted hexagonal ferrite, and
   the substituted hexagonal ferrite is a magnetoplumbite-type hexagonal ferrite having a formulation represented by Formula 1,

      **Formula 1** AFe₍₁₂₋ₓ₎AlₓO₁₉
   in Formula 1, A represents one or more kinds of atoms selected from the group consisting of Sr, Ba, Ca, and Pb, an atom represented by A includes Sr, and x satisfies 0.50 ≤ x ≤ 8.00.

### [Effects of Invention]

According to one aspect of the present invention, it is possible to provide an article including a radio wave absorber which can exhibit excellent radio wave absorption characteristics and in which scratches are hardly visible. In addition, according to one aspect of the present invention, it is possible to provide a radio wave absorber which can exhibit excellent radio wave absorption characteristics and in which scratches are hardly visible.

### [Description of Embodiments]

### [Article including radio wave absorber]

One aspect of the present invention relates to an article including a radio wave transmitter and a radio wave absorber.

### <Specific example of article>

Examples of the article include a radar. The radar is a device including a radio wave transmitter and measuring a direction in which an object is located, a distance to the object, and the like by receiving a reflected wave of a radio wave transmitted from the radio wave transmitter. Specific examples of the radar include an onboard radar, a ship radar, and an aircraft control radar. In addition, specific examples of the article include a wireless apparatus such as a mobile phone internal sensor and a biological information sensor. The radio wave transmitter may be disposed, for example, in a radio wave transmitting and receiving unit. For the structure of the article, the details of the radio wave transmitter, and the like, a known technology related to an article including a radio wave transmitter and a radio wave absorber can be applied.

### [Radio wave absorber]

In the present invention and the present specification, the "radio wave" means an electromagnetic wave having a frequency of 3 terahertz (THz) or less. The "radio wave absorber" has radio wave absorbability with respect to radio waves of one or more frequencies.

### <Ten-point average roughness Rz>

The radio wave absorber included in the article includes one or more kinds of particles selected from the group consisting of magnetic particles and dielectric particles, and a binder, and a ten-point average roughness Rz of at least one of a pair of main surfaces facing each other of the radio wave absorber is 25 µm or more and Y µm or less. Here, the Y is a value calculated by "Y = λ × 1,000/10" in a case where a wavelength of the radio wave transmitted from the radio wave transmitter is defined as λ mm. That is, the Y is a value of 1/10 of the wavelength λ converted into a value displayed in a unit of µm. The wavelength λ can be calculated from the speed of light and the frequency of the radio wave by the following expression. The speed of light is 3 × 10⁸ m/sec. $λ \left(unit: mm\right) = 1 , 000 \times speed of light / frequency \left(unit: Hz\right)$

The λ is displayed in one digit after a decimal point in a unit of mm, and in a case where the calculated value includes a second digit or more after the decimal point, the second digit is rounded off and the third digit or more is truncated. For example, in a case of a frequency of 60 GHz, λ (mm) = 1,000 × 3 × 10⁸/(60 × 10⁹) = 5. Therefore, λ is 5.0 mm. In a case where the calculation is performed in the same manner, for example, λ is 3.9 mm in a case where the frequency is 77 GHz, and λ is 2.0 mm in a case where the frequency is 150 GHz.

A shape of the radio wave absorber is not particularly limited, and the radio wave absorber may have a planar shape, may have a three-dimensional shape, or may be a combination of a portion having a planar shape and a portion having a three-dimensional shape. Examples of the planar shape include a plate shape. The plate shape can also be referred to as a sheet shape, a film shape, or the like. Examples of the three-dimensional shape include a tubular shape (a cylindrical shape, a square tubular shape, or the like), and a horn shape. In any shape, a surface having the largest area and a surface facing the surface in the surface of the radio wave absorber are referred to as "main surface". The areas of the two main surfaces may be the same as or different from each other. The main surface may be a plane or a curved surface, or may be a surface including a plane portion and a curved surface portion. In addition, a positional relationship between the two main surfaces may be parallel or may not be parallel. For example, the plate-shaped radio wave absorber may have an upper surface, a lower surface, and four side surfaces positioned between the upper surface and the lower surface. For example, in a case where the area of each of the upper surface and the lower surface is larger than the area of each of the four side surfaces, the upper surface and the lower surface are "main surfaces". The tubular or horn-shaped radio wave absorber may have an inner surface, an outer surface, and two annular side surfaces positioned between these surfaces. For example, in a case where the area of each of the inner surface and the outer surface is larger than the area of each of the two side surfaces, the inner surface and the outer surface are "main surfaces".

In the radio wave absorber, any one main surface can receive irradiation of radio waves transmitted from a radio wave transmitter. As a form of the radio wave irradiation, there is a form in which the radio waves transmitted from the radio wave transmitter directly hit the main surface of the radio wave absorber, and there is also a form in which the reflected waves of the radio waves transmitted from the radio wave transmitter hit the main surface of the radio wave absorber. Specific examples thereof include a case where the radio waves transmitted from the radio wave transmitter directly hit the main surface of the radio wave absorber, a case where the reflected waves transmitted from the radio wave transmitter, reflected by the object, and returned hit the main surface of the radio wave absorber, and a case where the reflected waves reflected by the object and returned hit the main surface of the radio wave absorber after being reflected by a metal plate or the like (for example, a vehicle body structure, a frame, or the like) further disposed behind the article. Therefore, from the viewpoint of improving the performance of the article including the radio wave absorber (for example, improving the recognition accuracy of the radar), it is preferable that the radio wave absorber has excellent radio wave absorption characteristics measured on any one main surface capable of receiving the irradiation of the radio waves. In this regard, as a result of extensive studies, the present inventor has newly found that, in a case where a ten-point average roughness Rz of at least one main surface of the radio wave absorber is equal to or less than a value Y (µm) calculated by "Y = λ × 1000/10" in a case where a wavelength of the radio waves transmitted from the radio wave transmitter provided in the article together with the radio wave absorber is denoted by λ mm, the radio wave absorber can exhibit excellent radio wave absorption characteristics on such a main surface. The present inventor supposes that this is because, in a case where Rz is equal to or less than Y µm, it is possible to suppress the diffuse reflection of the radio waves transmitted from the radio wave transmitter on the main surface. As described above, in a case of a frequency of 60 GHz, λ is 5.0 mm. In this case, since Y = 500, Rz is 500 µm or less. In a case where the calculation is performed in the same manner, for example, in a case where the frequency is 77 GHz, since λ is 3.9 mm and Y is 390, Rz is 390 µm or less. In a case where the frequency is 150 GHz, since λ is 2.0 mm and Y is 200, Rz is 200 µm or less.

On the other hand, as a result of extensive studies, it has been clarified that, as the surface smoothness of the main surface of the radio wave absorber is increased, the scratch on the main surface is more easily visible. Therefore, from the viewpoint of making it difficult to visually recognize the scratchs on the main surface, Rz of the radio wave absorber is 25 µm or more, preferably 26 µm or more, and more preferably 27 µm or more, 28 µm or more, 29 µm or more, and 30 µm or more in this order.

In the radio wave absorber, the main surface in which Rz is 25 µm or more and Y µm or less may be at least one of the pair of main surfaces facing each other, and Rz of any one main surface may be 25 µm or more and Y µm or less. It is not essential that Rz is 25 µm or more and Y µm or less on both main surfaces. In a case where Rz is 25 µm or more and Y µm or less on both main surfaces, Rz on one main surface and Rz on the other main surface may be the same value or different values.

The "ten-point average roughness Rz" in the present invention and the present specification is Rz specified in JIS B0601: 1994, and is generally also called "Rzjis". The Rz is measured with a three-dimensional shape measuring instrument. For example, in the measurement of Rz described in the section of Examples later, a three-dimensional shape measuring instrument VR-3200 manufactured by KEYENCE CORPORATION was used as the three-dimensional shape measuring instrument.

The Rz is measured in a region randomly selected on the main surface as a measurement target, a measurement range is set to 18 mm × 6 mm, a measurement line length is set to 18 mm, the measurement is performed on each of three parallel lines (accordingly, the number of measurements N = 3), and an interval between two adjacent measurement lines is set to 3 mm. An arithmetic average of the measurement results of the measurement of N = 3 is defined as Rz on the main surface as a measurement target. Regarding the three parallel lines, the term "parallel" does not necessarily mean only parallel in a strict sense, but includes a range of errors that are usually allowed in the technical field to which the present invention belongs. The range of errors can mean, for example, a range less than strictly parallel ± 10°.

A method for controlling Rz of the main surface of the radio wave absorber will be described later.

Hereinafter, the radio wave absorber will be described in more detail.

### <Particles>

The radio wave absorber contains one or more kinds of particles selected from the group consisting of magnetic particles and dielectric particles. The radio wave absorber can also contain different kinds of particles in arbitrary ratio as the particles selected from the group consisting of magnetic particles and dielectric particles. In the present invention and the present specification, "magnetic" means ferromagnetic property, and "dielectric" means a substance having a volume resistivity (ρᵥ) at 20°C, which is an intrinsic value of the substance, of 1 × 10⁵ Ω·m or more.

### (Dielectric particles)

As the dielectric particles that can be contained in the radio wave absorber, particles of various dielectrics can be used. For example, carbon-based particles can be used as the dielectric particles. Here, the term "based" is used to mean "include". Examples of the carbon-based particles can include particles of various carbon-based materials such as carbon black and graphite.

### (Magnetic particles)

Examples of the magnetic particles that can be contained in the radio wave absorber include particles of various magnetic materials such as ferrite, iron oxide, cobalt, and chromium oxide. From the viewpoint of radio wave absorbability, as the magnetic particles, particles of a hexagonal ferrite are preferable. A type of the magnetic material constituting the magnetic particles can be confirmed by performing analysis by an X-ray diffraction method. For example, a powder of the magnetic particles can be taken out from the composition for producing a radio wave absorber or the radio wave absorber by a known method, and the taken-out powder can be analyzed by an X-ray diffraction method. Alternatively, a part of the powder of the magnetic particles used for preparing the composition for producing a radio wave absorber can be collected, and the collected powder can be analyzed by an X-ray diffraction method. Alternatively, it can be checked by, for example, the following method. A part or all of the radio wave absorber is finely chopped, immersed in a solvent (for example, hexafluoroisopropanol) for 1 or 2 days, and then dried. The dried radio wave absorber is further ground finely and subjected to an analysis according to the X-ray diffraction method.

### Particles of hexagonal ferrite

In one aspect, the radio wave absorber can contain particles of hexagonal ferrite as the magnetic particles. In the present invention and the present specification, the term "particles of a hexagonal ferrite" refers to magnetic particles in which a crystal structure of a hexagonal ferrite is detected as the main phase by analysis according to the X-ray diffraction method. The main phase refers to a structure to which the highest intensity diffraction peak attributes in the X-ray diffraction spectrum obtained according to the X-ray diffraction method. For example, in a case where the highest intensity diffraction peak is attributed to a hexagonal ferrite crystal structure in an X-ray diffraction spectrum obtained by the X-ray diffraction method, it is determined that the hexagonal ferrite crystal structure is detected as the main phase. In a case where only a single structure is detected according to the X-ray diffraction method, this detected structure is used as the main phase. The hexagonal ferrite crystal structure includes at least an iron atom, a divalent metal atom, and an oxygen atom, as a constituent atom. In the unsubstituted hexagonal ferrite, the atoms that constitute the crystal structure of the hexagonal ferrite are only the iron atom, the divalent metal atom, and the oxygen atom. On the other hand, the substituted hexagonal ferrite contains one or more kinds of other atoms together with the iron atom, the divalent metal atom, and the oxygen atom, as atoms that constitute the crystal structure of the hexagonal ferrite. These one or more kinds of other atoms are generally atoms that are substituted for a part of iron in the crystal structure of hexagonal ferrite. The divalent metal atom is a metal atom that can be a divalent cation as an ion, and examples thereof may include an alkaline earth metal atom such as a strontium atom, a barium atom, and a calcium atom, and a lead atom. In the present invention and the present specification, the hexagonal strontium ferrite particle means one in which the main divalent metal atom contained in this particle is a strontium atom, and the hexagonal barium ferrite particle means one in which the main divalent metal atom contained in this particle is a barium atom. The same applies to particles of other types of hexagonal ferrite. The main divalent metal atom means a divalent metal atom that occupies the largest amount among the divalent metal atoms contained in this particle in terms of % by atom. However, rare earth atoms shall not be included in the above divalent metal atoms. The term "rare earth atom" in the present invention and the present specification is selected from the group consisting of a scandium atom (Sc), an yttrium atom (Y), and a lanthanoid atom. The lanthanoid atom is selected from the group consisting of a lanthanum atom (La), a cerium atom (Ce), a praseodymium atom (Pr), a neodymium atom (Nd), a promethium atom (Pm), a samarium atom (Sm), an europium atom (Eu), a gadolinium atom (Gd), a terbium atom (Tb), a dysprosium atom (Dy), a holmium atom (Ho), an erbium atom (Er), a thulium atom (Tm), an ytterbium atom (Yb), and a lutetium atom (Lu).

Regarding the particle of the hexagonal ferrite, the hexagonal ferrite that constitutes the particle includes one or more kinds of hexagonal ferrites selected from the group consisting of hexagonal strontium ferrite, hexagonal barium ferrite, hexagonal calcium ferrite, and hexagonal lead ferrite. From the viewpoint of the radio wave absorbability in the high frequency band, it is preferably one or more kinds of hexagonal ferrites selected from the group consisting of hexagonal strontium ferrite, hexagonal barium ferrite, and hexagonal calcium ferrite, more preferably hexagonal strontium ferrite and/or hexagonal barium ferrite, and still more preferably hexagonal strontium ferrite.

In one form, the particles of the hexagonal ferrite can be particles of a magnetoplumbite-type (generally referred to as "M-type") hexagonal ferrite. The magnetoplumbite-type hexagonal ferrite has a formulation represented by a composition formula: AFe₁₂O₁₉ in a case of being an unsubstituted which does not contain an atom that substitutes iron. Here, A can represent one or more kinds of atoms selected from the group consisting of Sr, Ba, Ca, and Pb, and also includes a form in which two or more of these atoms are contained in arbitrary ratio.

The hexagonal ferrite that is preferable from the viewpoint of radio wave absorbability includes, for example, a substituted hexagonal ferrite. Specific examples of the substituted hexagonal ferrite include a substituted magnetoplumbite-type hexagonal ferrite in which a part of iron atoms of the magnetoplumbite-type hexagonal ferrite are substituted with an aluminum atom. As one form of such hexagonal ferrite, hexagonal ferrite having a composition represented by Formula 1 can be mentioned.

**Formula 1** AFe₍₁₂₋ₓ₎AlₓO₁₉

In Formula 1, A represents one or more kinds of atoms (hereinafter, also referred to as an "A atom") selected from the group consisting of Sr, Ba, Ca, and Pb, it may be only one kind of atom, it may contain two or more kinds of atoms in arbitrary ratio, and, from the viewpoint of improving the uniformity of the formulation between particles contained in the radio wave absorber, it is preferably only one kind of atom.
From the viewpoint of the radio wave absorbability in the high frequency band, A in Formula 1 is preferably one or more kinds of atoms selected from the group consisting of Sr, Ba, and Ca, and more preferably one or more kinds of atoms selected from the group consisting of Sr and Ba. It is still more preferable that Sr is contained, and it is even still more preferable that A is Sr.

In Formula 1, x satisfies 0.50 ≤ x ≤ 8.00.

In one form, x can satisfy 1.50 ≤ x ≤ 8.00. From the viewpoint of the radio wave absorbability in the high frequency band, x is preferably 1.50 or more, more preferably more than 1.50, still more preferably 2.00 or more, and even still more preferably more than 2.00. In addition, from the viewpoint of magnetic properties, x is 8.00 or less, preferably less than 8.00, more preferably 6.00 or less, and still more preferably less than 6.00.

Specific examples of the form which is the substituted hexagonal ferrite represented by Formula 1 belonging to a magnetoplumbite type and in which x satisfies 1.50 ≤ x ≤ 8.00 include SrFe_{(9.58)}Al_{(2.42)}O₁₉, SrFe_{(9.37)}Al_{(2.63)}O₁₉, SrFe_{(9.27)}Al_{(2.73)}O₁₉, SrFe_{(9.85)}Al_{(2.15)}O₁₉, SrFe(10.00)Al(2.00)O19, SrFe(9.74)Al(2.26)O19, SrFe(10.44)Al(1.56)O19, SrFe(9.79)Al(2.21)O19, SrFe(9.33)Al(2.67)O19, SrFe(7.88)Al(4.12)O19, SrFe(7.04)Al(4.96)O19, SrFe(7.37)Al(4.63)O19, SrFe(6.25)Al(5.75)O19, SrFe(7.71)Al(4.29)O19, Sr(0.80)Ba(0.10)Ca(0.10)Fe(9.83)Al(2.17)O19, BaFe_{(9.50)}Al_{(2.50)}O₁₉, CaFe_{(10.00)}Al_{(2.00)}O₁₉, and PbFe_{(9.00)}Al_{(3.00)}O₁₉. In addition, specific examples thereof also include the substituted hexagonal strontium ferrite described in the section of Examples described later. The formulation of the magnetic particle can be confirmed, for example, by subjecting a dissolution solution in which the magnetic particle is dissolved, to a high-frequency inductively coupled plasma emission spectroscopic analysis. Specific examples of the checking method include a method described in the section of Examples described later. Alternatively, after exposing a cross-section by cutting the radio wave absorber or the like, the exposed cross-section is subjected to, for example, energy dispersive X-ray analysis, whereby the formulation of the magnetic particle contained in the radio wave absorber can be checked.

In addition, in one form, x can satisfy 0.50 ≤ x < 1.50. From the viewpoint of radio wave absorbability in a high frequency band, x can be 0.50 or more, and is preferably 0.70 or more. In addition, from the viewpoint of magnetic properties, x is preferably less than 1.50 and more preferably 1.20 or less. Examples of the magnetoplumbite-type substituted hexagonal ferrite represented by Formula 1, in which x satisfies 0.50 ≤ x < 1.50, include the substituted hexagonal strontium ferrites described in the section of Examples later.

In one form, in the substituted hexagonal ferrite, the crystal phase can be a single phase, and a plurality of crystal phases can be included. It is preferable that the crystal phase is a single phase, and it is more preferable that the substituted hexagonal ferrite is a magnetoplumbite-type substituted hexagonal ferrite in which the crystal phase is a single phase.
The case where the "crystal phase is a single phase" refers to a case where only one kind of diffraction pattern showing any crystal structure is observed in analysis carried out according to the X-ray diffraction method. The analysis according to the X-ray diffraction method can be carried out, for example, according to the method described in the section of Examples described later. In a case where a plurality of crystal phases are included, two or more kinds of diffraction patterns showing any crystal structure are observed in the analysis according to the X-ray diffraction method. Regarding the attribution of the diffraction pattern, for example, a database of the International Centre for Diffraction Data (ICDD, registered trademark) can be referenced. For example, regarding the diffraction pattern of the magnetoplumbite-type hexagonal ferrite containing Sr, "00-033-1340" of the International Centre for Diffraction Data (ICDD) can be referred to. However, in a case where a part of iron atoms are substituted with a substituent atom such as an aluminum atom, the peak position shifts from the peak position observed in a case where the substituent atom is not included.

### Method for manufacturing particles of hexagonal ferrite

There are various methods as a manufacturing method of the particles of hexagonal ferrite, and in a case where the radio wave absorber includes the particles of hexagonal ferrite, the manufacturing method of the particles of hexagonal ferrite is not particularly limited. Hereinafter, a solid phase method will be described as an example of the method for manufacturing particles of a hexagonal ferrite. The solid phase method is a method for producing particles of a hexagonal ferrite by sintering a mixture obtained by mixing a plurality of solid raw materials.

Examples of the solid raw material that is used in the solid phase method include a compound of an iron atom and a compound of an A atom, and further include a compound of a substituent atom in a case of producing a powder of a substituted hexagonal ferrite. These compounds can be an oxide, a carbonate, or the like. The A atom and the substituent atom are as described above. The mixing ratio between a plurality of solid raw materials may be determined according to the desired hexagonal ferrite composition. A raw material mixture can be obtained by mixing a plurality of solid raw materials at the same time or sequentially mixing them in any order. In addition, the mixing of the solid raw materials is not limited to being performed under dry conditions. Under wet conditions, for example, a solvent such as water may be added, and mixing may be carried out in a slurry state. The mixing of the solid raw materials can be carried out by a commercially available mixing device or a mixing device having a publicly known configuration. An example of the mixing device is a paint shaker. The mixing can be carried out, for example, in an ambient air atmosphere at room temperature.

After the above mixing, the obtained raw material mixture can be sintered. In this sintering, the crystallization of the raw material mixture can be promoted, whereby the crystal structure of the hexagonal ferrite can be formed. Regarding the sintering conditions, the sintering temperature can be set, for example, in a range of 1,000°C to 1,500°C. The sintering temperature can be, for example, the atmosphere temperature inside the device in which sintering is carried out (for example, the temperature inside the heating furnace). The sintering time can be in a range of 1 hour to 6 hours. However, the above ranges are described as examples, and the sintering may be carried out under conditions under which the crystal structure of the hexagonal ferrite is capable of being formed. The calcination can be performed, for example, in the atmosphere.

In the sintering, it is also possible to add a fusing agent to the powder of the raw material mixture and sinter it. As the fusing agent, various fusing agents can be used, and examples thereof include SrCl₂, SrCl₂·6H₂O, CaCl₂·2H₂O, MgCl₂, KCl, NaCl, BaCl₂·2H₂O, and Na₂B₄O₇. The adding amount thereof is, for example, preferably 0.1 to 10 parts by mass and more preferably 0.1 to 8.0 parts by mass with respect to 100 parts by mass of the powder of the raw material mixture.

The raw material mixture before sintering can be subjected to a dry-type or wet-type pulverization step, and/or the sintered product after the sintering can be subjected to a dry-type or wet-type pulverization step. In a case of carrying out the pulverization step, it is possible to adjust the size of the particles that constitute the powder of the hexagonal ferrite. The pulverization can be carried out with a known pulverizing unit such as a mortar and pestle or a pulverizer (a cutter mill, a ball mill, a beads mill, a roller mill, a jet mill, a hammer mill, an attritor, or the like).

The sintered product obtained after the sintering can be subjected to a step such as pulverization, as necessary, and then subjected to an annealing treatment. The annealing treatment can be carried out, for example, in a heating furnace having a furnace temperature of 500°C to 1,100°C for about 1 to 10 hours.

One or more publicly known steps such as washing and drying can be optionally carried out before and/or after the various steps described above.

### (Volume filling rate)

The radio wave absorber contains the particles and a binder. In the radio wave absorber, a filling rate of the particles is not particularly limited. In one form, the filling rate can be 35% by volume or less and can be, for example, in a range of 15% to 35% by volume in terms of the volume filling rate. In addition, in another form, the volume filling rate can be 35% by volume or more. In this case, the volume filling rate can be, for example, in a range of 35% to 60% by volume, and it can also be in a range of 35% to 50% by volume. The volume filling rate means a content based on a volume, in which the total volume of the radio wave absorber is 100% by volume. The volume filling rate of the particles in the composition for producing a radio wave absorber can also be in the above-described range. For the composition for producing a radio wave absorber, the volume filling rate means a content based on a volume, in which the total volume of the composition for producing a radio wave absorber (here, in a case where a solvent is contained, the solvent is excluded. The same applies hereinafter.) is 100% by volume.

The volume filling rate of the particles can be obtained from the composition of the composition for producing a radio wave absorber. Regarding the radio wave absorber, for example, the volume filling rate of the particles can be determined by collecting the particles from the radio wave absorber by a known method and calculating "(volume of collected particles/total volume of radio wave absorber) × 100". Here, the total volume of the radio wave absorber and the volume of the particles can be obtained by a known method. Alternatively, in a case where the composition of the composition used for preparing a radio wave absorber is known, the volume filling rate of the particles in the radio wave absorber can be determined from this known composition.

In addition, the volume filling rate of the particles in the radio wave absorber can also be determined by the following method using a cross-section SEM image acquired by a scanning electron microscope (SEM).

A measurement sample having a square plane, one side of which has a length of 5 mm, is cut out from a randomly determined position of the radio wave absorber to be measured. A sample for cross-section observation is prepared from the cut-out sample. The sample for cross-section observation is prepared by focused ion beam (FIB) processing. The prepared cross-section observation sample is observed by SEM, and a cross-sectional image (cross-sectional SEM image) is captured. As the SEM, a field emission-scanning electron microscope (FE-SEM) is used. Using the FE-SEM, a cross-section observation sample is set on a stage so that the FIB-processed cross-section faces upward, and a cross-section SEM image with a visual field of 30 µm × 40 µm is obtained under the conditions of an acceleration voltage of 15 kV and an observation magnification of 3000 folds. The obtained cross-section SEM image is subjected to binarization processing, and the proportion (in terms of the area) of the particles is calculated.

The above operation is carried out on five measurement samples cut out from different positions of the radio wave absorber to be measured, and the volume filling rate of the particles can be determined as the arithmetic average of the obtained five values. It is noted that, as necessary, the elemental analysis of the cross-section observation sample can be carried out and the portion of the particles in the cross-section SEM image can also be specified.

The volume filling rates of the other components described in the present specification can also be determined in the same manner as described above.

### <Binder>

The radio wave absorber contains the particles and further contains a binder. The binder can be, for example, a resin, and examples of the resin include a thermoplastic resin and a thermosetting resin.

Examples of the thermoplastic resin include an acrylic resin, polyacetal, polyamide, polyethylene, polypropylene, polyethylene terephthalate, polybutylene terephthalate, a polyethylene terephthalate-1,4-cyclohexanedimethanol terephthalate copolymer, polylactic acid, polycarbonate, polystyrene, polyphenylene sulfide, polyvinyl chloride, an acrylonitrile butadiene styrene (ABS) resin obtained by copolymerization of acrylonitrile, butadiene, and styrene; and an acrylonitrile styrene (AS) resin obtained by copolymerization of acrylonitrile and styrene.

Examples of the thermosetting resin include a phenol resin, an epoxy resin, a melamine resin, a urea resin, an unsaturated polyester, a diallyl phthalate resin, a urethane resin, and a silicon resin.

The binder can also be rubber. From viewpoints that the mixability with the magnetic particles is good and the radio wave absorber having more excellent durability, weather fastness, and impact resistance can be manufactured, examples of the rubber include butadiene rubber, isoprene rubber, chloroprene rubber, halogenated butyl rubber, fluororubber, urethane rubber, acrylic rubber (abbreviation: ACM) obtained by copolymerization of an acrylic acid ester (for example, ethyl acrylate, butyl acrylate, or 2-ethylhexyl acrylate) and another monomer, ethylene-propylene rubber obtained by coordination polymerization of ethylene and propylene using a Ziegler catalyst, butyl rubber (abbreviation: IIR) obtained by copolymerization of isobutylene and isoprene, styrene butadiene rubber (abbreviation: SBR) obtained by copolymerization of butadiene and styrene, acrylonitrile butadiene rubber (abbreviation: NBR) obtained by copolymerization of acrylonitrile and butadiene, and silicone rubber.

In a case of manufacturing a radio wave absorber including rubber as a binder, the composition may include various additives such as a vulcanizing agent, a vulcanization aid, a softening agent, and a plasticizer, in addition to the rubber. Examples of the vulcanizing agent include sulfur, an organic sulfur compound, and a metal oxide.

Examples of the binder include a thermoplastic elastomer (TPE). Examples of the thermoplastic elastomer include an olefin-based thermoplastic elastomer (a thermoplastic olefinic elastomer (TPO)), a styrene-based thermoplastic elastomer (a thermoplastic styrenic elastomer (TPS)), an amide-based thermoplastic elastomer (a thermoplastic polyamide elastomer (TPA), and a polyester-based thermoplastic elastomer (a thermoplastic copolyester (TPC)).

The radio wave absorber may include only one kind of binder and may include two or more kinds thereof. The volume filling rate of the binder in the radio wave absorber is not particularly limited, and it is, for example, preferably 65% by volume or more, more preferably 65% by volume or more and 92% by volume or less, and still more preferably 65% by volume or more and 85% by volume or less. In a case where the radio wave absorber contains two or more kinds of binders, the volume filling rate means the total volume filling rate of the two or more kinds of binders. This point also identically applies to the volume filling rates of other components. The volume filling rate of the binder in the composition for producing a radio wave absorber can also be within the above-described range.

### <Additives>

The radio wave absorber may randomly contain or may not contain one or more additives in arbitrary ratio. Examples of the additive include an antioxidant, a light stabilizer, a dispersant, a dispersing aid, a fungicide, an antistatic agent, a plasticizer, an impact improver, a crystal nucleating agent, a lubricant, a surfactant, a pigment, a dye, a filler, a mold release agent (fatty acid, a fatty acid metal salt, an oxyfatty acid, a fatty acid ester, an aliphatic partially saponified ester, paraffin, a low-molecular-weight polyolefin, a fatty acid amide, an alkylenebis fatty acid amide, an aliphatic ketone, a fatty acid lower alcohol ester, a fatty acid polyhydric alcohol ester, a fatty acid polyglycol ester, a modified silicone, and the like), a processing aid, an antifogging agent, a drip inhibitor, and an antibacterial agent. In the additive, one component may have two or more functions.

### (Antioxidant)

In one form, examples of the preferred additive include an antioxidant.

The antioxidant is not particularly limited, and a publicly known antioxidant can be used.

Examples of the antioxidant are described in, for example, "Comprehensive Technology for Polymer Stabilization - Mechanism and Application Development -" published by CMC Publishing Co., Ltd., supervised by Yasukazu Okatsu. This description is incorporated in the present specification by reference.

Examples of the kind of the antioxidant include a phenol-based antioxidant, an amine-based antioxidant, a phosphorus-based antioxidant, and a sulfur-based antioxidant.

As the antioxidant, it is preferable to use a phenol-based antioxidant and/or an amine-based antioxidant in combination with a phosphorus-based antioxidant and/or a sulfur-based antioxidant.

Examples of the phenol-based antioxidant include ADEKA STAB AO-20, ADEKA STAB AO-30, ADEKA STAB AO-40, ADEKA STAB AO-50, ADEKA STAB AO-60, ADEKA STAB AO-80, and ADEKA STAB AO-330, manufactured by ADEKA Corporation; and IRGANOX 1010, IRGANOX 1035, IRGANOX 1076, IRGANOX 1098, IRGANOX 1135, IRGANOX 1330, IRGANOX 1726, IRGANOX 245, IRGANOX 259, IRGANOX 3114, and IRGANOX 565, manufactured by BASF Japan Ltd. The above "ADEKA STAB" and "IRGANOX" are both registered trademarks.

Examples of the amine-based antioxidants include Sanol LS-770, Sanol LS-765, and Sanol LS-2626, manufactured by Mitsubishi-Chemical Foods Corporation; ADEKA STAB LA-77, ADEKA STAB LA-57, ADEKA STAB LA-52, ADEKA STAB LA-62, ADEKA STAB LA-63, ADEKA STAB LA-67, ADEKA STAB LA-68, and ADEKA STAB LA-72, manufactured by ADEKA Corporation; and TINUVIN 123, TINUVIN 144, TINUVIN 622, TINUVIN 765, and TINUVIN 944, manufactured by BASF Japan Ltd. It is noted that the above "ADEKA STAB" and "TINUVIN" are both registered trademarks.

In addition, an amine-based compound capable of quenching radicals can also be used as the antioxidant. Examples of such an amine-based compound include polyethylene glycol bis TEMPO [Sigma-Aldrich Co., LLC] and sebacic acid bis TEMPO. Here, "TEMPO" is an abbreviation for tetramethylpiperidin-1-oxyl.

Examples of the phosphorus-based antioxidant include ADEKA STAB PEP-8, ADEKA STAB PEP-36, ADEKA STAB HP-10, and ADEKA STAB 2112, manufactured by ADEKA Corporation; and IRGAFOS 168 manufactured by BASF Japan Ltd. It is noted that the above "ADEKA STAB" and "IRGAFOS" are both registered trademarks.

Examples of the sulfur-based antioxidant include ADEKA STAB AO-412S and ADEKA STAB AO-503S, manufactured by ADEKA Corporation. The above "ADEKA STAB" is a registered trademark.

Among the above, the phenol-based antioxidant is preferably one or more selected from the group consisting of ADEKA STAB AO-20, ADEKA STAB AO-60, ADEKA STAB AO-80, and IRGANOX 1010, the amine-based antioxidant is preferably ADEKA STAB LA-52, the phosphorus-based antioxidant is preferably ADEKA STAB PEP-36, and the sulfur-based antioxidant is preferably ADEKA STAB AO-412S.

In a case of containing an antioxidant, the above radio wave absorber may contain only one kind of antioxidant or may contain two or more kinds of antioxidants.

In a case where the above radio wave absorber contains an antioxidant, the content of the antioxidant in the radio wave absorber is not particularly limited, and it is, for example, preferably 0.1 parts by mass to 10 parts by mass and more preferably 0.5 parts by mass to 5 parts by mass with respect to 100 parts by mass of the binder from the viewpoint of both suppressing the decomposition of the binder and suppressing the bleeding of the antioxidant.

### (Light stabilizer)

In one form, examples of the preferred additive include a light stabilizer.

Examples of the light stabilizer include HALS (that is, a hindered amine light stabilizer), an ultraviolet absorber, and a singlet oxygen quencher.

The HALS may be a high-molecular-weight HALS, a low-molecular-weight HALS, or a combination of a high-molecular-weight HALS and a low-molecular-weight HALS.

In a case of containing a light stabilizer, the above radio wave absorber may contain only one kind of light stabilizer or may contain two or more kinds of light stabilizers.

### High-molecular-weight HALS

In the present invention and the present specification, the term "high-molecular-weight HALS" means a hindered amine light stabilizer having a weight-average molecular weight of more than 1,000.

Examples of the high-molecular-weight HALS include, as an oligomer-type HALS, poly [6-(1,1,3,3-tetramethylbutyl)imino-1,3,5-triazine-2,4-diyl] [(2,2,6,6-tetramethyl-4-piperidyl)imino]hexamethylene [(2,2,6,6-tetramethyl-4-piperidyl)imino] and dimethyl succinate-1-(2-hydroxyethyl)-4-hydroxy-2,2,6,6-tetramethylpiperidine polycondensate. Examples of the commercially available high-molecular-weight HALS product include CHIMASSORB 944LD and TINUVIN 622LD, manufactured by BASF Japan Ltd. It is noted that the above "CHIMASSORB" and "TINUVIN" are both registered trademarks.

The weight-average molecular weight (Mw) in the present invention and the present specification is a value measured according to gel permeation chromatography (GPC). In the measurement using the gel permeation chromatography (GPC), HLC (registered trademark) -8220GPC [manufactured by Tosoh Corporation] can be used as the measurement device, TSKgel (registered trademark) Super HZM-M [4.6 mm ID ×15 cm, manufactured by Tosoh Corporation], Super HZ4,000 [4.6 mm ID x 15 cm, manufactured by Tosoh Corporation], Super HZ3,000 [4.6 mm ID x 15 cm, manufactured by Tosoh Corporation], and Super HZ2,000 [4.6 mm ID x 15 cm, manufactured by Tosoh Corporation] are connected one by one, respectively, in series and can be used as the column, and tetrahydrofuran (THF) can be used as the eluant.

The measurement conditions can be a sample concentration of 0.2% by mass, a flow rate of 0.35 mL/min, a sample injection amount of 10 µL, and a measurement temperature of 40°C, and a differential refractive index (RI) detector can be used as the detector.

The calibration curve can be created using "Standard sample TSK standard, polystyrene", "F-40", "F-20", "F-4", "F-1", "A-5000", "A-2500", and "A-1000", manufactured by Tosoh Corporation.

In a case where the radio wave absorber contains a high-molecular-weight HALS, the content of the high-molecular-weight HALS in the composition and the radio wave absorber is not particularly limited, and is, for example, preferably 0.2% by mass to 10% by mass with respect to the total mass of the radio wave absorber.

The content of the high-molecular-weight HALS in the above radio wave absorber is preferably made to be 0.2% by mass or more with respect to the total mass of the radio wave absorber from the viewpoint of improving weather fastness.

In a case where the content of the high-molecular-weight HALS in the radio wave absorber is 10% by mass or less with respect to the total mass of the radio wave absorber, the decrease in mechanical strength and the occurrence of brooming tend to be capable of being suppressed.

### Low-molecular-weight HALS

In the present invention and the present specification, the term "low-molecular-weight HALS" means a hindered amine light stabilizer having a molecular weight of 1,000 or less (preferably 900 or less and more preferably 600 to 900).

Examples of the low-molecular-weight HALS include tris(2,2,6,6-tetramethyl-4-piperidyl)benzene-1,3,5-tricarboxylate, tris(2,2,6,6-tetramethyl-4-piperidyl)-2-acetoxypropane-1,2,3-tricarboxylate, tris(2,2,6,6-tetramethyl-4-piperidyl)-2-hydroxypropane-1,2,3-tricarboxylate, tris(2,2,6,6-tetramethyl-4-piperidyl)triazine-2,4,6-tricarboxylate, tris(2,2,6,6-tetramethyl-4-piperidyl)butane-1,2,3-tricarboxylate, tetrakis(2,2,6,6-tetramethyl-4-piperidyl)propane-1,1,2,3-tetracarboxylate, tetrakis(2,2,6,6-tetramethyl-4-piperidyl) 1,2,3,4-butanetetracarboxylate, tetrakis(1,2,2,6,6-pentamethyl-4-piperidyl) 1,2,3,4-butanetetracarboxylate, and 2-(3,5-di-t-butyl-4-hydroxybenzyl)-2-n-butylmalonate bis(1,2,2,6,6-pentamethyl-4-piperidyl). Examples of the commercially available low-molecular-weight HALS product include ADEKA STAB LA-57, and ADEKA STAB LA-52, manufactured by ADEKA Corporation; and TINUVIN 144 manufactured by BASF Japan Ltd. It is noted that the above "ADEKA STAB" and "TINUVIN" are both registered trademarks.

In a case where the radio wave absorber contains a low-molecular-weight HALS, the content of the low-molecular-weight HALS in the radio wave absorber is not particularly limited, and is, for example, preferably 0.2% by mass to 10% by mass with respect to the total mass of the composition or the radio wave absorber.

The content of the low-molecular-weight HALS in the above radio wave absorber is preferably made to be 0.2% by mass or more with respect to the total mass of the radio wave absorber from the viewpoint of improving weather fastness.

In a case where the content of the low-molecular-weight HALS in the radio wave absorber is 10% by mass or less with respect to the total mass of the radio wave absorber, the decrease in mechanical strength and the occurrence of brooming tend to be capable of being suppressed.

### Ultraviolet absorber

Examples of the ultraviolet absorber include benzotriazole-based ultraviolet absorbers such as 2-(2'-hydroxy-3',5'-di-t-butylphenyl)benzotriazole, 2-(3,5-di-t-amyl-2-hydroxyphenyl)benzotriazole, 2-(2'-hydroxy-5'-methyl-phenyl)benzotriazole, 2-(2'-hydroxy-5'-t-octylphenyl)benzotriazole, 2-(2'-hydroxy-3',5'-di-t-amylphenyl)benzotriazole, 2-[2'-hydroxy-3'-(3'',4'',5'',6''-tetrahydrophthalimide methyl)-5'-methylphenyl]benzotriazole, 2,2'-methylenebis[4-(1,1,3,3-tetramethylbutyl)-6-(2H-benzotriazole-2-yl)phenol], 2-[2-hydroxy-3,5-bis(α,α-dimethylbenzyl)phenyl]-2H-benzotriazole, 2-(2-hydroxy-4-octyloxyphenyl)-2H-benzotriazole, and 2-(2H-benzotriazole-2-yl)-4-methyl-6-(3,4,5,6-tetrahydrophthalimidylmethyl)phenol; benzophenone-based ultraviolet absorbing agents such as 2-hydroxy-4-methoxybenzophenone, 2,4-dihydroxybenzophenone, 2,2'-dihydroxy-4-methoxybenzophenone, 2,2'-dihydroxy-4,4'-dimethoxybenzophenone, 2-hydroxy-4-n-octoxybenzophenone, 2,2',4,4'-tetrahydroxybenzophenone, 4-dodecyloxy-2-hydroxybenzophenone, a 3,5-di-t-butyl-4-(hydroxybenzoyl)benzoic acid n-hexadecyl ester, 1,4-bis(4-benzoyl-3-hydroxyphenoxy)butane, 1,6-bis(4-benzoyl-3-hydroxyphenoxy)hexane; and cyanoacrylate-based ultraviolet absorbers represented by ethyl-2-cyano-3,3-diphenylacrylate.

Examples of the commercially available ultraviolet absorber include TINUVIN 320, TINUVIN 328, TINUVIN 234, TINUVIN 1577, TINUVIN 622, and IRGANOX series, manufactured by BASF Japan Ltd.; ADEKA STAB LA31 manufactured by ADEKA Corporation; and SEESORB 102, SEESORB 103, and SEESORB 501, manufactured by SHIPRO KASEI KAISHA, Ltd. It is noted that the above-described "TINUVIN", "IRGANOX", "ADEKA STAB", and "SEESORB" are all registered trademarks.

In a case where the radio wave absorber contains an ultraviolet absorber, the content of the ultraviolet absorber in the composition and the radio wave absorber is not particularly limited, and is, for example, preferably 0.2% by mass to 10% by mass with respect to the total mass of the radio wave absorber.

The content of the ultraviolet absorber in the above radio wave absorber is preferably set to 0.2% by mass or more with respect to the total mass of the radio wave absorber from the viewpoint of improving weather fastness.

In a case where the content of the ultraviolet absorber in the radio wave absorber is 10% by mass or less with respect to the total mass of the radio wave absorber, the decrease in mechanical strength and the occurrence of brooming tend to be capable of being suppressed.

### - Singlet oxygen quencher -

In a case where the above radio wave absorber contains a singlet oxygen quencher, the content of the singlet oxygen quencher in the radio wave absorber is not particularly limited, and it is, for example, preferably 0.2% by mass to 10% by mass with respect to the total mass of the radio wave absorber.

The content of the singlet oxygen quencher in the above radio wave absorber is preferably made to be 0.2% by mass or more with respect to the total mass of the radio wave absorber from the viewpoint of improving weather fastness.

In a case where the content of the singlet oxygen quencher in the radio wave absorber is 10% by mass or less with respect to the total mass of the radio wave absorber, the decrease in mechanical strength and the occurrence of brooming tend to be capable of being suppressed.

In a case of containing a light stabilizer, the above radio wave absorber may contain only one kind of light stabilizer or may contain two or more kinds of light stabilizers.

The composition for producing a radio wave absorber may or may not contain a solvent. In a case where the composition contains a solvent, the solvent is not particularly limited, and examples thereof include water, an organic solvent, and a mixed solvent of water and an organic solvent.

Examples of the organic solvent include alcohols such as methanol, ethanol, n-propanol, i-propanol, and methoxypropanol, ketones such as acetone, methyl ethyl ketone, and cyclohexanone, tetrahydrofuran, acetonitrile, ethyl acetate, and toluene. Among these, the solvent is preferably ketones and more preferably cyclohexanone from the viewpoint of drying rate. In a case where the composition contains a solvent, the content of the solvent in the composition is not particularly limited and may be appropriately determined.

The composition for producing a radio wave absorber can be prepared by mixing the above-described components. The mixing method is not particularly limited, and examples thereof include a method of mixing by stirring. As the stirring unit, a publicly known stirring device can be used. Examples of the stirring device include mixers such as a paddle mixer and an impeller mixer. A stirring time may be set according to the type of the stirring device, the formulation of the composition, and the like.

For example, the composition can be prepared as a kneaded material by kneading, while heating, a mixture obtained by mixing the particles, the binder, and as necessary, a solvent, an additive, and the like. The kneaded material can be obtained in any shape, for example, an aggregated shape, a pellet, or a filament that can be used for a three-dimensional (3D) printer. The kneaded material is molded into a desired shape by a publicly known molding method such as extrusion molding, press molding, injection molding, in-mold forming, or 3D print shaping, whereby a radio wave absorber (a molded product) can be obtained. The shape of the radio wave absorber is as described above. The radio wave absorber can be formed of only one kind of composition, or can be a combination (for example, a laminate) of two or more kinds having different compositions.

Examples of a method of controlling the Rz of the main surface of the radio wave absorber include the following methods.

A method of providing unevenness by performing an etching treatment on a surface of a molding die (for example, a metal molding die) used for molding a composition for producing a radio wave absorber to obtain a formed article.

A method of producing a three-dimensional structure (formed article) in which unevenness is formed by a 3D printer.

A method of forming unevenness by performing a sandblast treatment on a formed article obtained by molding a composition for producing a radio wave absorber.

For example, the thickness of the radio wave absorber is preferably 20.0 mm or less, more preferably 10.0 mm or less, and still more preferably 5.0 mm or less, from the viewpoint of easiness of handling. From the viewpoint of mechanical properties, the thickness is preferably 1.0 mm or more and more preferably 2.0 mm or more. In a case where the radio wave absorber is a laminate, the thickness means the total thickness of the radio wave absorber that constitutes the laminate. The thickness of the radio wave absorber can be measured using a digital length measuring machine and, for example, can be an arithmetic average of the measured values measured at nine locations which are randomly selected.

The radio wave absorber can be incorporated into various articles to which radio wave absorbability is desired to be imparted. For example, the plate-shaped radio wave absorber can be incorporated into an article in any form as it is or by being bent at any portion. In addition, a radio wave absorber molded into a desired shape by injection molding or the like can also be incorporated into an article.

By the way, the on-vehicle radar, which has been attracting attention in recent years, is a radar that uses radio waves in the millimeter wave frequency band. The millimeter wave is an electromagnetic wave having a frequency of 30 GHz to 300 GHz. The radio wave absorber is suitable, for example, as a radio wave absorber that is incorporated on a front side (an incident side of the radio wave incident from the outside) of the radio wave transmitting and receiving unit in the on-vehicle radar in order to reduce the side lobe of the on-vehicle millimeter-wave radar.

In addition, the radio wave absorber can also be incorporated into a radio wave absorbing article that is used in the field of wireless technology such as a motion sensor. The radio wave absorber is suitable as a radio wave absorber for improving recognition accuracy by removing unnecessary radio waves in wireless apparatussuch as a mobile phone internal sensor and a biological information sensor.

An article including the above-described radio wave absorber and a radio wave transmitter can be called a radio wave absorbing article. The radio wave absorbing article is an article having radio wave absorbability with respect to radio waves having one or more frequencies, and the radio wave absorbability with respect to radio waves having one or more frequencies can be obtained by including a radio wave absorber.

### [Radio wave absorber]

One aspect of the present invention relates to a radio wave absorber including one or more kinds of particles selected from the group consisting of magnetic particles and dielectric particles, and a binder, in which a ten-point average roughness Rz of at least one of a pair of main surfaces facing each other is 25 µm or more and 500 µm or less.

In the above-described radio wave absorber, the Rz of at least one main surface is 500 µm or less, preferably 455 µm or less, and more preferably 450 µm or less, 400 µm or less, 350 µm or less, 300 µm or less, 250 µm or less, 200 µm or less, 150 µm or less, and 100 µm or less in this order. Since such a radio wave absorber can exhibit excellent radio wave absorption characteristics with respect to radio waves in a frequency band of 60 GHz or more (therefore, a wavelength λ is 5.0 mm or less), the radio wave absorber is preferable as a radio wave absorber to be incorporated into a radio wave absorbing article in a frequency band of 60 GHz or more. The radio wave absorbing article in a frequency band of 60 GHz or more is an article having radio wave absorbability with respect to radio waves having one or more frequencies in a frequency band of 60 GHz or more. The same applies to the radio wave absorbing article in the following frequency band. The radio wave absorbing article in a frequency band of 60 GHz or more can be, for example, a radio wave absorbing article in a frequency band of 60 GHz or more and 150 GHz or less, and can also be a radio wave absorbing article in a frequency band of 60 GHz or more and 77 GHz or less.

The Rz of the above-described radio wave absorber is 25 µm or more for the reason described above. The preferred range of Rz is as described above for the radio wave absorber provided in the article. Other details of the above-described radio wave absorber are as described above for the radio wave absorber provided in the article.

### Examples

Hereinafter, the present invention will be described based on Examples. However, the present invention is not limited to the embodiments shown in Examples. Unless otherwise specified, steps and evaluations described below were carried out in an environment of the ambient air atmosphere. In addition, the steps and evaluations in the following description were carried out at an atmosphere temperature of 23°C ± 1°C, unless otherwise specified.

### (Magnetic particles)

The magnetic particles used for producing the samples described below are as follows.
Magnetic particles 1: in Formula 1, A = Sr, x = 0.75
Magnetic particles 2: in Formula 1, A = Sr, x = 1.65
Magnetic particles 3: in Formula 1, A = Sr, x = 3.52

### <Verification of crystal structure>

The crystal structure of the magnetic material constituting each of the magnetic particles 1 to 3 was confirmed by X-ray diffraction analysis. As the measurement device, X'Pert Pro manufactured by PANalytical Co., Ltd., which is a powder X-ray diffractometer, was used. The measurement conditions were as follows.

### - Measurement conditions -

X-ray source: CuKα ray
[Wavelength: 1.54 Å (0.154 nm), output: 40 mA, 45 kV]
Scan range: 20° <2θ < 70°
   Scan interval: 0.05°
Scan speed: 0.33 °/min

As a result of the X-ray diffraction analysis, it was confirmed that the magnetic particles 1 have a magnetoplumbite-type crystal structure and are a single-phase powder of a magnetoplumbite-type hexagonal ferrite that does not include a crystal structure other than the magnetoplumbite-type crystal structure.

### <Confirmation of composition>

The composition of the magnetic body constituting each of the magnetic particles 1 to 3 was confirmed by high-frequency inductively coupled plasma emission spectroscopic analysis. Specifically, the checking was carried out by the following method.

A container (a beaker) containing 12 mg of the magnetic particles and 10 mL of an aqueous hydrochloric acid solution of a concentration of 4 mol/L was held on a hot plate at a set temperature of 120°C for 3 hours to obtain a dissolution solution. 30 mL of pure water was added to the obtained dissolution solution, which is then filtered using a membrane filter having a filter pore diameter of 0.1 µm. Elemental analysis of the filtrate obtained as described above was carried out using a high frequency inductively coupled plasma emission spectrometer [ICPS-8100, manufactured by Shimadzu Corporation]. Based on the obtained elemental analysis results, a content of each atom with respect to 100% by atom of the iron atom was obtained. Then, based on the obtained content, the composition of the magnetic material was checked. As a result, it was confirmed that the composition of each of the magnetic particles 1 to 3 was a composition in which A in Formula 1 was Sr and x was the value described above.

### [Production of molding die]

Seven molding dies (molding dies 1 to 7) in which a plurality of irregularities were provided on only one molding surface for molding one main surface of a molded article among two molding surfaces by chemical etching were prepared.

The depths of the recessed portions were as follows: molding die 1: about 1 µm, molding die 2: about 10 µm, molding die 3: about 30 µm, molding die 4: about 100 µm, molding die 5: about 300 µm, molding die 6: about 500 µm, and molding die 7: about 750 µm.

Each sample in the table below is a radio wave absorber molded by injection molding using the following molding die.
Sample 1-1, sample 2-1, and sample 3-1: radio wave absorbers molded by injection molding using the molding die 1;
Sample 1-2, sample 2-2, and sample 3-2: radio wave absorbers molded by injection molding using the molding die 2;
Sample 1-3, sample 2-3, and sample 3-3: radio wave absorbers molded by injection molding using the molding die 3;
Sample 1-4, sample 2-4, and sample 3-4: radio wave absorbers molded by injection molding using the molding die 4;
Sample 1-5, sample 2-5, and sample 3-5: radio wave absorbers molded by injection molding using the molding die 5;
Sample 1-6, sample 2-6, and sample 3-6: radio wave absorbers molded by injection molding using the molding die 6;
Sample 1-7, sample 2-7, and sample 3-7: radio wave absorbers molded by injection molding using the molding die 7.

### [Production of radio wave absorber]

Each sample (radio wave absorber) shown in the table below was produced by the following method.

A powder of magnetic particles shown in the table below was added to a binder (polypropylene resin (NOVATEC PP MA3H manufactured by Japan Polypropylene Corporation)) in an amount such that a volume filling rate of the powder of the magnetic particles in the radio wave absorber to be produced was 20% by volume, and the mixture was kneaded using a biaxial kneader and then cut using a pelletizer to obtain a composition for producing a radio wave absorber (injection molding pellet).

The obtained pellets were put into an injection molding machine from a hopper of the injection molding machine to perform injection molding, thereby obtaining a molded article (radio wave absorber) as an A5 size flat plate (148 mm × 210 mm). As the molding die for injection molding, the molding die described above was used.

For each of the produced radio wave absorbers, a thickness was obtained as an arithmetic average of measured values measured at nine randomly selected points using a digital measuring machine [Litematic (registered trademark) VL-50A manufactured by Mitutoyo Corporation]. The thickness of each radio wave absorber was 2.5 mm.

A molded article was produced by the same method as the sample shown in each of Tables 1 to 3 below, except that a molding die in which chemical etching was not performed on any of the two molding surfaces was used. The molded article produced in this way was used as a reference sample for the sample shown in each of Tables 1 to 3 in the evaluation of radio wave absorption characteristics described later.

For each of the samples shown in the table below, 12 molded articles (radio wave absorbers) were produced, one was used for the measurement of Rz and the measurement of the thickness, another was used for the evaluation of the visibility of scratches, and the remaining 10 were used for the evaluation of radio wave absorption characteristics.

### [Measurement of Rz]

For each sample shown in the table below, as a three-dimensional shape measuring instrument, a three-dimensional shape measuring instrument VR-3200 manufactured by KEYENCE CORPORATION was used to measure Rz of a main surface formed by a molding surface of each molding die on a side where unevenness was provided, by the method described above.

### [Evaluation method]

### <Radio wave absorption characteristics>

The reflection attenuation amount (unit: dB) of each sample shown in the table below was measured by the following method.

The reflection attenuation amount at a frequency of 60 GHz or 77 GHz was obtained by the following method.

For each sample, as a measurement device, a vector network analyzer (product name: N5225B) manufactured by keysight and a horn antenna (product name: RH12S23) manufactured by KEYCOM Corporation were used, and by the free space method, the main surface formed by the molding surface of each molding die on the side where unevenness was provided was directed to the incidence side, the S parameter was measured with an incidence angle of 0° and a sweep frequency of 60 GHz to 90 GHz, and S11 of the S parameter at a frequency (60 GHz, 77 GHz) shown in each table below was obtained.

The reflection attenuation amount at a frequency of 150 GHz was obtained by the above-described method, except that a horn antenna (product name: RH06S10) manufactured by KEYCOM Corporation was used and the sweep frequency was set to 110 GHz to 170 GHz.

For each frequency (60 HGz, 77 GHz, 150 GHz), the arithmetic average of the values of S11 (number of measurements N = 10) obtained for 10 radio wave absorbers was defined as the reflection attenuation amount of each sample. For the reference sample for each sample, the reflection attenuation amount was also obtained with N = 10. For the evaluation standard, a case where the amount of change in the reflection attenuation amount with respect to the reflection attenuation amount of the reference sample was 0 dB or more and less than 1.5 dB was defined as "A", a case where the amount of change was 1.5 dB or more and less than 3.0 dB was defined as "B", and a case where the amount of change was 3.0 dB or more was defined as "C".

### <Visibility of scratch>

For each sample shown in the table below, a scratch was made on the main surface formed by the molding surface of each molding die on the side where unevenness was provided, using a pencil with a hardness of 4H and a load of 750 g, with a scratch tester (HEIDON 14 type manufactured by Shinto Scientific Co., Ltd.) at a speed of 4 mm/sec.

For the evaluation standard, a case where a scratch was visually confirmed was defined as "C", and a case where a scratch was not visually confirmed was defined as "A", by visually observing the scratched surface. The evaluation of all samples was performed by the same operator, and the distance between the operator and the main surface of the observation target in the evaluation of all samples was the same.

The above results are shown in the following tables.

**[Table 1]**

| Frequency of 60 GHz (wavelength λ = 5.0 mm, Y = 500) | Sample 1-1 | Sample 1-2 | Sample 1-3 | Sample 1-4 | Sample 1-5 | Sample 1-6 | Sample 1-7 |
|---|---|---|---|---|---|---|---|
| Magnetic particle | Magnetic particle 1 | Magnetic particle 1 | Magnetic particle 1 | Magnetic particle 1 | Magnetic particle 1 | Magnetic particle 1 | Magnetic particle 1 |
| Rz[µm] | 1 | 10 | 30 | 95 | 298 | 451 | 608 |
| Visibility of scratch | C | C | A | A | A | A | A |
| Radio wave absorption characteristics | A | A | A | A | A | A | C |

**[Table 2]**

| Frequency of 77 GHz (wavelength λ = 3.9 mm, Y = 200) | Sample 2-1 | Sample 2-2 | Sample 2-3 | Sample 2-4 | Sample 2-5 | Sample 2-6 | Sample 2-7 |
|---|---|---|---|---|---|---|---|
| Magnetic particle | Magnetic particle 2 | Magnetic particle 2 | Magnetic particle 2 | Magnetic particle 2 | Magnetic particle 2 | Magnetic particle 2 | Magnetic particle 2 |
| Rz[µm] | 1 | 10 | 30 | 94 | 297 | 449 | 607 |
| Visibility of scratch | C | C | A | A | A | A | A |
| Radio wave absorption characteristics | A | A | A | A | A | B | C |

**[Table 3]**

| Frequency of 150 GHz (wavelength λ = 2.0 mm, Y = 200) | Sample 3-1 | Sample 3-2 | Sample 3-3 | Sample 3-4 | Sample 3-5 | Sample 3-6 | Sample 3-7 |
|---|---|---|---|---|---|---|---|
| Magnetic particle | Magnetic particle 3 | Magnetic particle 3 | Magnetic particle 3 | Magnetic particle 3 | Magnetic particle 3 | Magnetic particle 3 | Magnetic particle 3 |
| Rz[µm] | 1 | 10 | 29 | 95 | 299 | 450 | 609 |
| Visibility of scratch | C | C | A | A | A | A | A |
| Radio wave absorption characteristics | A | A | A | A | C | C | C |

From the results shown in each table, it can be confirmed that the sample in which the Rz of the main surface obtained by the above method was 25 µm or more and Y µm or less was hardly visible as a scratch and exhibited excellent radio wave absorption characteristics (the evaluation result of the radio wave absorption characteristics was A).

In addition, from the results shown in Table 1 and Table 2, it can be confirmed that the sample in which the Rz of the main surface obtained by the above method was 500 µm or less exhibited favorable radio wave absorption characteristics in a frequency band of 60 GHz or more and 77 GHz or less (the evaluation result of the radio wave absorption characteristics was A or B).

### [Industrial Applicability]

One aspect of the present invention is useful, for example, in a technical field of performing various autonomous drive controls such as autonomous drive control of an automobile, a wireless technology field such as a motion sensor, and the like.

## Claims

1. An article comprising:
a radio wave transmitter; and
a radio wave absorber,
wherein the radio wave absorber contains one or more kinds of particles selected from the group consisting of magnetic particles and dielectric particles, and a binder, and
a ten-point average roughness Rz of at least one of a pair of main surfaces of the radio wave absorber facing each other is 25 µm or more and Y µm or less,
where the Y is a value calculated by Y = λ × 1000/10 in a case where a wavelength of a radio wave transmitted from the radio wave transmitter is defined as λ mm.

2. The article according to claim 1, wherein the Y is 500 or less.

3. The article according to claim 1,
wherein the particles are magnetic particles, and the magnetic particles are particles of a hexagonal ferrite.

4. The article according to claim 3, wherein the hexagonal ferrite is a substituted hexagonal ferrite.

5. The article according to claim 4,
wherein the substituted hexagonal ferrite is a magnetoplumbite-type hexagonal ferrite having a formulation represented by Formula 1,
**Formula 1** AFe₍₁₂₋ₓ₎AlₓO₁₉
in Formula 1, A represents one or more kinds of atoms selected from the group consisting of Sr, Ba, Ca, and Pb, and x satisfies 0.50 ≤ x ≤ 8.00.

6. The article according to claim 5, wherein the atom represented by A in Formula 1 includes Sr.

7. The article according to claim 1,
wherein the Y is 500 or less,
the particles are magnetic particles,
the magnetic particles are particles of a hexagonal ferrite,
the hexagonal ferrite is a substituted hexagonal ferrite, and
the substituted hexagonal ferrite is a magnetoplumbite-type hexagonal ferrite having a formulation represented by Formula 1:
**Formula 1** AFe₍₁₂₋ₓ₎AlₓO₁₉
in Formula 1, A represents one or more kinds of atoms selected from the group consisting of Sr, Ba, Ca, and Pb, x satisfies 0.50 ≤ x ≤ 8.00, and in Formula 1, an atom represented by A includes Sr.

8. A radio wave absorber comprising:
one or more kinds of particles selected from the group consisting of magnetic particles and dielectric particles; and a binder, in which a ten-point average roughness Rz of at least one of a pair of main surfaces facing each other is 25 µm or more and 500 µm or less.

9. The radio wave absorber according to claim 8,
wherein the particles are magnetic particles, and the magnetic particles are particles of a hexagonal ferrite.

10. The radio wave absorber according to claim 9, wherein the hexagonal ferrite is a substituted hexagonal ferrite.

11. The radio wave absorber according to claim 10,
wherein the substituted hexagonal ferrite is a magnetoplumbite-type hexagonal ferrite having a formulation represented by Formula 1:
**Formula 1** AFe₍₁₂₋ₓ₎AlₓO₁₉
in Formula 1, A represents one or more kinds of atoms selected from the group consisting of Sr, Ba, Ca, and Pb, and x satisfies 0.50 ≤ x ≤ 8.00.

12. The radio wave absorber according to claim 11, wherein the atom represented by A in Formula 1 includes Sr.

13. The radio wave absorber according to claim 8,
wherein the particles are magnetic particles,
the magnetic particles are particles of a hexagonal ferrite,
the hexagonal ferrite is a substituted hexagonal ferrite, and
the substituted hexagonal ferrite is a magnetoplumbite-type hexagonal ferrite having a formulation represented by Formula 1:
**Formula 1** AFe₍₁₂₋ₓ₎AlₓO₁₉
in Formula 1, A represents one or more kinds of atoms selected from the group consisting of Sr, Ba, Ca, and Pb, an atom represented by A includes Sr, and in Formula 1, x satisfies 0.50 ≤ x ≤ 8.00.
